Europäisches Patentamt

European Patent Office

Office européen des brevets

(19)

(11) Veröffentlichungsnummer : **0 119 552**
**B1**

(12) **EUROPÄISCHE PATENTSCHRIFT**

(45) Veröffentlichungstag der Patentschrift :
16.06.87

(51) Int. Cl.⁴ : **H 04 B 3/44**, H 03 K 17/08

(21) Anmeldenummer : 84102453.2

(22) Anmeldetag : 07.03.84

(54) Schaltungsanordnung zum selbsttätigen Schliessen einer Fernspeiseschleife.

(30) Priorität : 11.03.83 DE 3308762

(43) Veröffentlichungstag der Anmeldung :
26.09.84 Patentblatt 84/39

(45) Bekanntmachung des Hinweises auf die Patenterteilung : 16.06.87 Patentblatt 87/25

(84) Benannte Vertragsstaaten :
AT BE CH DE FR GB IT LI NL SE

(56) Entgegenhaltungen :
EP-A- 0 061 343
DE-A- 3 134 840
DE-B- 1 267 267
US-A- 4 084 207
ELEKTROTECHNIK, Band 65, Nr. 4, 28. Februar 1983,
Seiten 14-17, Würzburg, DE. W. BÖSTERLING et al.:
"Praxis mit dem GTO"
UND-ODER-NOR + STEUERUNGSTECHNIK, Band 12,
Nr. 11, 1982, Seiten 24-29, Mainz, DE. W. T.
HOHMANN: "Elektronische Relais für Geräteanwendungen"
ELEKTRONIK, Nr. 22, November 1981, Seiten 57-62,
München, DE. C. DESAI et al.: "Über- und Unterspan-
nungs-Überwachungsschaltungen"
BROWN, BOVERI & CIE.: "Silizium Stromrichter Handbuch", Mai 1971, Seiten 76-94, 252-257, Baden, CH.
K. HEUMANN et al.: "Thyristoren", 1969, Seiten 37-
42, 222-231, B.G. Teubner, Stuttgart, DE.

(73) Patentinhaber : **Siemens Aktiengesellschaft Berlin
und München**
**Wittelsbacherplatz 2**
**D-8000 München 2 (DE)**

(72) Erfinder : **Kraicar, Heinz, Dipl.-Ing.**
**Lindenberg 60 A**
**D-8134 Pöcking (DE)**

## Beschreibung

Die Erfindung bezieht sich auf eine Schaltungsanordnung zum selbsttätigen Schließen einer unterbrochenen Fernspeiseschleife vor einer Unterbrechungsstelle, für Fernspeiseeinrichtungen, die elektrische Verbraucher mittels Gleichstrom-Reihenspeisung speisen, wobei im weiterführenden Teil eines der Fernspeisepfade eine Erregerwicklung eines Relais liegt und in einem Querzweig eine Serienschaltung mit einem Ruhekontakt des Relais, einem Widerstand und der bezogen auf den Fernspeisestrom in Durchlaßrichtung gepolten Anoden-Kathodenstrecke eines Thyristors angeordnet ist und das Relais bei Strömen oberhalb eines vorgegebenen Bruchteils vom Nennwert des Fernspeisestromes erregt und bei Strömen unter einem vorgegebenen Bruchteil vom Nennwert des Fernspeisestromes abgefallen ist, wobei der Steueranschluß des Thyristors bei einer Unterbrechung im weiterführenden Teil der Fernspeiseschleife erst nach Ablauf der Prellzeit des Relaiskontaktes mit der zur Zündung des Thyristors erforderlichen Spannung beaufschlagt ist. Unter der Durchlaßrichtung des Thyristors ist in diesem Zusammenhang die Richtung von der Anode zur Kathode zu verstehen.

Eine derartige Schaltungsanordnung ist bereits aus der DE-PS 1 267 267 bekannt. Bei der bekannten Schaltungsanordnung handelt es sich um einen Schaltzusatz, der als Hauptschaltelement ein Relais und einen Thyristor enthält. Der Thyristor hat die Aufgabe, den Stromfluß über den sich schließenden Kontakt zu verhindern und erst dann leitend zu werden, wenn der Kontakt endgültig geschlossen ist. Auf diese Weise wird erreicht, daß der Relaiskontakt den Fernspeisestrom nicht zu schalten braucht.

Untersuchungen im Rahmen der Erfindung haben jedoch ergeben, daß beim Schalten des Relais und des Thyristors unzulässig große Beanspruchungen der Thyristoren auftreten können, insbesondere bei atmosphärischen Beeinflussungen der Fernspeisestrecke.

Aufgabe der Erfindung ist es, eine Schaltungsanordnung der eingangs genannten Art derart auszubilden, daß der Thyristor seinerseits wirksam gegen unerwünschte Beanspruchungen geschützt ist.

Gemäß der Erfindung wird die Schaltungsanordnung zur Lösung dieser Aufgabe in der im kennzeichnenden Teil des Patentanspruchs 1 angegebenen Weise ausgebildet. Der Serienschwingkreis, bestehend aus der in Serie zum Thyristor liegenden Drossel und dem parallel zum Thyristor angeordneten RC-Glied, begrenzt in an sich bekannter Weise den Spannungsanstieg beim Anschalten des Thyristors an die Fernspeisestrecke (vgl. dazu z. B. Brown, Boveri & Cie : « Silizium Stromrichter Handbuch » Mai 1971, Seiten 76 bis 94 und 252 bis 257). Die parallel zur Drossel angeordnete Diode wirkt dabei als Abmagnetisierungdiode und sorgt dafür, daß sich die Spannung an der Drossel nicht umpolen kann. Gegebenenfalls kann zur Beschleunigung der Abmagnetisierung in Serie zur Diode eine entgegengesetzt gepolte Z-Diode angeordnet sein. Der weitere Widerstand bildet mit dem in Serie zum Thyristor liegenden Wiederstand einen Spannungsteiler, der — bedingt durch die in Serie zum weiteren Widerstand angeordnete Diode — nur für entgegengesetzt zum Fernspeisestrom gerichtete Beeinflussungsströme wirksam ist und bei Unterbrechung einer sich in Betrieb befindlichen Fernspeisestrecke und Schließen des Relaiskontaktes dafür sorgt, daß keine Einschaltströme entstehen. Die Induktivität der Drossel wird zweckmäßigerweise derart bemessen, daß für den Thyristor die Anstiegsgeschwindigkeit des Anodenstromes und die Anstiegsgeschwindigkeit der Anoden-Kathoden-Spannung kleiner als die für den Thyristor vorgegebenen Grenzwerte sind.

Durch die erfindungsgemäßen Maßnahmen ergibt sich der Vorteil, daß der den Relaiskontakt schützende Thyristor seinerseits sowohl beim Schließen einer unterbrochenen Fernspeiseschleife als auch gegen schädliche Beeinflussungen wirksam geschützt ist, die durch Blitzschlag bei abgeschalteter Fernspeisestrecke entstehen könnten.

In Weiterbildung der Erfindung sind die Anoden-Kathoden-Strecke des Thyristors und die Drossel unmittelbar in Serie geschaltet und parallel zu der Serienschaltung aus der Anoden-Kathoden-Strecke des Thyristors und der Drossel ein Varistor angeordnet. Auf diese Weise wird die Anstiegsgeschwindigkeit der Spannung, die bei Unterbrechung der Fernspeiseschleife an den Thyristor gelangt, im Zusammenwirken mit der Drossel und der parallel zum Thyristor liegenden RC-Serienschaltung wirksam begrenzt.

Zwischen der Anode und der Steuerelektrode des Thyristors liegt zweckmäßigerweise ein Zweipol mit einer Z-Diodenanordnung, deren Zenerspannung derart bemessen ist, daß zwischen der Anode und der Steuerelektrode der Thyristors ein Zweipol mit einer Z-Diodenanordnung liegt, deren Zenerspannung derart bemessen ist, daß der Thyristor etwa beim 1,2-fachen des Maximalwertes der am Ausgang der Speiseeinrichtung auftretenden Fernspeisespannung über den Zweipol gezündet wird. Der Maximalwert tritt dann auf, wenn die Speiseeinrichtung in den Zustand der Spannungsbegrenzung übergeht.

Die Induktivität der Drossel ist vorzugsweise derart bemessen, daß die Anstiegsgeschwindigkeit des Anodenstromes nach einem Zünden des Thyristors über die Z-Diodenanordnung unterhalb des für den Thyristor vorgegebenen Grenzwertes liegt.

Die Nennspannung des Varistors wird zweckmäßigerweise größer bemessen als die Spannung, die bei Unterbrechung der sich in Betrieb befindlichen Fernspeiseschleife und dem dadurch hervorgerufenen Schließen des Ruhekontaktes am Varistor maximal auftritt.

Legt man in Serie zur Z-Diodenanordnung eine Diode, deren Polung zu der der Z-Diodenanordnung entgegengesetzt ist, so ergibt sich der Vorteil, daß bei Strömen, die durch Blitzschlag entstehen und in Sperrichtung des Thyristors fließen, die Steuerelektrode des Thyristors nicht in Sperrichtung überbeansprucht werden kann.

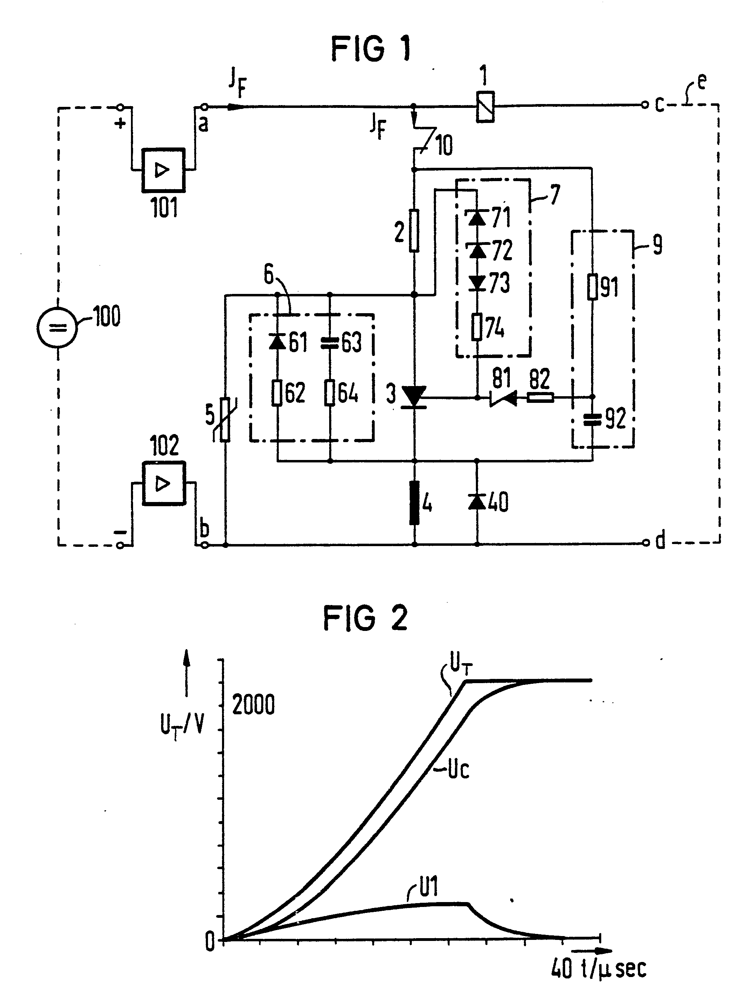

Die Erfindung wird anhand des in Fig. 1 gezeigten Ausführungsbeispiels und des in Fig. 2 dargestellten Spannungsdiagramms näher erläutert.

Es zeigen :

Figur 1   einen Schaltzusatz, bei dem ein zum Schutz eines Relaiskontaktes vorgesehener Thyristor seinerseits gegen unerwünschte Beanspruchung geschützt ist und

Figur 2   den zeitlichen Verlauf der am Thyristor wirksamen Spannung.

Bei dem in Fig. 1 gezeigten Fernspeisekreis werden Zwischenverstärkerstellen über eine mittels des Gleichstromumrichters 100 einseitig gespeiste Fernspeiseschleife mit konstandem Gleichstrom $J_F$ ferngespeist. Von den Zwischenstellen der Nachrichtenübertragungseinrichtung ist in der Figur nur eine dargestellt. Jede Zwischenstelle enthält zwei Verstärker bzw. Regeneratoren 101 und 102, von denen der eine mit seinem Speiseeingang in die eine Ader und der andere mit seinem Speiseeingang in die andere Ader der Fernspeiseleitung eingeschleift ist. Die Adern der Fernspeiseleitung bzw. die Strompfade der Fernspeiseschleife können z. B. die Innenleiter von Koaxialkabeln einer Vierdraht-Nachrichtenübertragungseinrichtung oder Adern eines eigenen Fernspeisekabels sein. Gegebenenfalls kann einer der Verstärker bzw. Regeneratoren entfallen oder es können mehrere Verstärker bzw. Regeneratoren an ein und dieselbe Fernspeiseleitung angeschlossen sein: Anstelle von Verstärkern bzw. Regeneratoren können andere elektrische Verbraucher ferngespeist werden.

Jede Zwischenstelle ist mit einem Schaltzusatz versehen, der im Zuge der Fernspeiseleitung auf der dem Gleichstromumrichter 100 abgewandten Seite der Verstärker 101 und 102 angeordnet ist. Der Schaltzusatz bildet einen Vierpol in Form eines Halbgliedes. Im Querzweig des Halbgliedes liegt der Ruhekontakt 10 des Relais 1. Der Längszweig ist durch die Wicklung des Relais 1 gebildet.

Wird die Fernspeiseeinrichtung in Betrieb genommen, so ist die Fernspeiseschleife zunächst über den Querzweig des Schaltzusatzes geschlossen. Bei intakter Fernspeiseschleife teilt sich der Fernspeisestrom, welcher ein Konstantstrom ist, entsprechend dem Widerstand der Querzweiges und dem Schleifenwiderstand des nachfolgenden Teiles der Fernspeiseschleife auf den Querzweig und den nachfolgenden Teil der betriebsmäßig vorgesehenen Fernspeiseschleife auf. Der durch das Relais 1 fließende Strom erzeugt eine Durchflutung, die das Relais 1 bei intakter Fernspeiseschleife zum Ansprechen bringt. Der Ruhekontakt 10 öffnet, so daß der Querzweig stromlos wird und der gesamte Fernspeisestrom über den Längszweig mit dem Relais 1 fließt.

Bei einer Unterbrechung der Fernspeiseschleife fallen die Relais der Schaltzusätze ab, so daß die Querzweige der Schaltzusätze geschlossen werden. Ausgehend von der Speisestelle spricht ein Relais nach dem anderen an, bis eine ersatzweise Fernspeiseschleife aufgebaut ist, die bis zu dem unmittelbar vor der Unterbrechungsstelle e gelegenen Schaltzusatz reicht.

Im weiterführenden Teil des einen Fernspeisepfades liegt die Erregerwicklung des Relais 1. In einem Querzweig ist eine Serienschaltung mit dem Ruhekontakt 10 des Relais 1, dem Widerstand 2 und der bezogen auf den Fernspeisestrom in Durchlaßrichtung gepolten Anoden-Kathoden-Strecke des Thyristors 3 und der Drossel 4 angeordnet.

Das Relais 1 ist bei Strömen oberhalb eines vorgegebenen Bruchteiles vom Nennwert des Fernspeisestromes erregt und bei Strömen unter einem vorgegebenen Bruchteil vom Nennwert des Fernspeisestromes abgefallen. Dem Steueranschluß des Thyristors 3 ist eine über den Ruhekontakt 10 des Relais 1 an die Fernspeiseschleife geführte Verzögerungsschaltung 9 vorgeschaltet. Diese aus einem Widerstand 91 und einem Kondensator 92 bestehende Verzögerungsschaltung ist derart bemessen, daß der Steueranschluß des Thyristors bei einer Unterbrechung im weiterführenden Teil der Fernspeiseschleife erst nach Ablauf der Prellzeit des Relaiskontaktes mit der zur Zündung des Thyristors erforderlichen Spannung beaufschlagt wird. Die Steuerelektrode des Thyristors 3 ist über die Bauteile 81 und 82 an den Verbindungspunkt des Widerstandes 91 mit dem Kondensator 92 angeschlossen.

Parallel zur Anoden-Kathoden-Strecke des Thyristors 3 liegt die RC-Serienschaltung, bestehend aus dem Kondensator 63 und dem Widerstand 64.

Parallel zur Drossel 4 ist die für den Fernspeisestrom in Sperrichtung gepolte Diode 40 angeordnet. Die Anoden-Kathoden-Strecke des Thyristors 3 und die Drossel 4 sind unmittelbar in Serie geschaltet. Parallel zu dieser Serienschaltung ist der Varistor 5 angeordnet.

Zwischen der Anode und der Steuerelektrode des Thyristors 3 liegt der Zweipol 7, der aus den mit gleicher Polung in Serie geschalteten Z-Dioden 71 und 72, der zu den Z-Dioden entgegengesetzt gepolten Diode 73 und dem Widerstand 74 besteht.

Parallel zur Anoden-Kathoden-Strecke des Thyristors 3 ist eine Serienschaltung aus dem Widerstand 62 und der für den Fernspeisestrom in Sperrichtung gepolten Diode 61 angeordnet.

Nach Schließen des Ruhekontaktes 10 und Leitendwerden des Thyristors 3 entladen sich die Kabelkapazitäten der Fernspeiseschleife über den Kontakt 10 des Relais 1 und den Thyristor 3. Die Anstiegsgeschwindigkeit des im Querzweig fließenden Stromes wird durch die als Drosselspule ausgebildete Drossel 4 begrenzt. Unmittelbar nach Schließen des Kontaktes 10 übernimmt der Thyristor 3 die gesamte zwischen den Strompfaden a-c und b-d der Fernspeiseschleife bzw. den zur Fernspeisung dienenden Adern liegende Spannung bzw. Kabelspannung $U_k$. Zur Begrenzung der Anstiegsgeschwindigkeit der Spannung sind der Kondensator 63 und der Widerstand 64 vorgesehen. Diese zwei Komponenten wirken jedoch nur dann im gewünschten Sinne, wenn die Drosselspule 4 eine genügend hohe Induktivität hat. Die Schaltmittel 4, 63 und 64 bilden einen Reihenschwingkreis, auf den die Kabelspannung $U_k$ als Rechteckspannung aufgeschaltet wird. Die Kabelspannung $U_k$ wird durch Schließen des Kontaktes 10 auf den Schwingkreis 4, 63, 64 aufgeschaltet.

In Fig. 2 ist die am Widerstand 64 abfallende Spannung U1 und die sich am Kondensator 63 aufbauende Spannung $U_c$ dargestellt. Die Summe dieser beiden Spannungen ist die Spannung $U_T$, welche am Thyristor anliegt. Durch geeignete Dimensionierung des Widerstandes 64, des Kondensators 63 und der Drossel 4 kann die Anstiegsflanke der Spannung $U_T$ in den zulässigen Grenzen gehalten werden. Die Spannung $U_T$ kann nicht größer werden als die Kabelspannung $U_k$, da sich die Spannung an der Drossel 4 wegen der als Abmagnetisierungsdiode wirkenden Diode 40 nicht umpolen kann. Die Drossel 4 ist daher nicht nur hinsichtlich der Anstiegsgeschwindigkeit des Stromes, sondern auch hinsichtlich der Anstiegsgeschwindigkeit der Spannung dimensioniert.

Die kritischere Anstiegsgeschwindigkeit der am Thyristor liegenden Spannung tritt jedoch bei Blitzschlägen auf. Dabei können die Adern der Fernspeisekabel gegen Erde kurzzeitig eine hohe Spannung annehmen. Diese Adern sind zweckmäßigerweise über Ableiter mit dem Außenleiter des Koaxialkabels verbunden und schützen daher die Isolation des Kabels. Wenn die Außenleiter geerdet sind, können bei Auftreten der genannten Spannungen die Ableiter zünden. Durch die Streuung der Zündspannungen der Ableiter Zünden die Ableiter nicht gleichzeitig. Dadurch kann auch zwischen den Adern der Fernspeisekabel kurzzeitig eine hohe Spannung, die in der Folge Stoßspannung genannt wird, auftreten.

Tritt bei der bekannten Schaltungsanordnung eine solche Beeinflussung bei einer nicht eingeschalteten Strecke, also bei einer Strecke, deren Relaiskontakte geschlossen sind, auf, so liegt am Thyristor die gesamte Stoßspannung an. Diese Stoßspannung kann bei 3-kV-Ableitern bis zu 5 kV betragen. Thyristoren in dieser Spannungsklasse sind jedoch sehr groß und aufwendig.

Durch den Varistor 5 wird die genannte Stoßspannung wesentlich heruntergesetzt. Da der Varistor 5 jedoch im Verhältnis zu Z-Dioden einen erheblichen inneren Widerstand besitzt, tritt am Varistor 5 bei einer Beeinflussung durch Blitzschlag immer noch etwa eine Spannung in der Größe des 1,5- bis 2-fachen der Fernspeisespannung auf. Dies bedeutet für die Anstiegsgeschwindigkeit der Spannung ebenfalls höhere Werte. Das R-C-L-Glied 4, 63, 64 ist zweckmäßigerweise so dimensioniert, daß bei Anlegen der Varistorspannung als Rechteckspannung, die das 1,5- bis 2-fache der Fernspeisespannung beträgt, noch keine zu hohen Anstiegsgeschwindigkeiten der am Thyristor auftretenden Spannung entstehen. Diese Varistorspannung würde in voller Höhe auch am Thyristor 3 anstehen, wenn die Z-Dioden 71, 72 nicht vorhanden wären. Diese Z-Dioden sorgen dafür, daß der Thyristor 3 etwa bei dem 1,2-fachen der Fernspeisespannung verzögerungsfrei durchzündet. D. h. am Thyristor 3 kann nie eine höhere Spannung als die von den Z-Dioden vorgegebene Spannung anliegen. An die Drossel 4 wird die zusätzliche Forderung gestellt, daß die Anstiegsgeschwindigkeit des Stromes, nach Zünden des Thyristors 3 durch die Z-Dioden, nicht zu hoch wird.

Der Varistor 5 ist so dimensioniert, daß bei Unterbrechung einer sich in Betrieb befindlichen Fernspeisestrecke und Schließen des Relaiskontaktes 10 die Spannung am Varistor 5 nicht über die Nennspannung des Varistors ansteigt, um vom Relaiskontakt 10 zu große Einschaltströme fernzuhalten.

Bei den vorstehenden Betrachtungen wurde angenommen, daß der durch Blitz bedingte Strom im Thyristor 3 in Durchlaßrichtung fließt. Wenn jedoch bei Beeinflussung durch Blitzschlag — abgeschaltete Fernspeisestrecke vorausgesetzt — der Strom in entgegengesetzter Richtung fließt, dann ist die Drossel 4 wegen der Diode 40 unwirksam und damit auch der Widerstand 64 und der Kondensator 63. Die Spannung am Varistor 5 würde sofort in voller Größe und annähernd in voller Steilheit am Thyristor 3 anstehen. Dies verhindert der Widerstand 62, der parallel zum Thyristor 3 geschaltet ist. Der Widerstand 62 bildet zusammen mit dem Widerstand 2 einen Spannungsteiler und wird so niederohmig gemacht, daß weder die Höhe der Spannung, noch die Anstiegsgeschwindigkeit der am Thyristor auftretenden Spannung zu hoch wird. Die Diode 61 verhindert, daß bei Unterbrechung einer sich im Betrieb befindlichen Fernspeisestrecke und Schließen des Relaiskontaktes 10 Einschaltströme entstehen. Die Diode 73 verhindert, daß bei Strömen, die durch Blitzschlag entstehen und in Sperrichtung des Thyristors 3 fließen, die Steuerelektrode des Thyristors 3 in Sperrichtung überbeansprucht wird.

## Patentansprüche

1. Schaltungsanordnung zum selbsttätigen Schließen einer unterbrochenen Fernspeiseschleife vor einer Unterbrechungsstelle, für Fernspeiseeinrichtungen, die elektrische Verbraucher mittels Gleichstrom-Reihenspeisung speisen, wobei im weiterführenden Teil eines der Fernspeisepfade eine Erregerwicklung eines Relais (1) liegt und in einem Querzweig eine Serienschaltung mit einem Ruhekontakt (10) des Relais, einem Widerstand (2) und der bezogen auf den Fernspeisestrom ($I_F$) in Durchlaßrichtung gepolten Anoden-Kathoden-Strecke eines Thyristors (3) angeordnet ist, wobei dem Steueranschluß des Thyristors eine über den Ruhekontakt an die Fernspeiseschleife geführte Verzögerungsschaltung (9) vorgeschaltet ist, dadurch gekennzeichnet, daß in Serie zur Anoden-Kathoden-Strecke des Thyristors (3) eine Drossel (4) angeordnet ist und daß parallel zur Anoden-Kathoden-Strecke des Thyristors (3) eine RC-Serienschaltung (63, 64) liegt, und daß parallel zur Drossel (4) eine für den Fernspeisestrom ($I_F$) in Sperrichtung gepolte Diode (40) angeordnet ist, und daß parallel zur Anoden-Kathoden-Strecke des Thyristors (3) ein derart bemessener weiterer Widerstand (62) angeordnet ist, daß bei Beeinflussungsströmen, deren Polarität entgegengesetzt zur Richtung des Fernspeisestromes ($I_F$) ist, sowohl die Größe als auch die Anstiegsgeschwindigkeit der zwischen Anode und Kathode des Thyristors (3) auftretenden Spannung unterhalb der für den Thyristor vorgegebenen Grenzwerte bleibt, und daß in Serie zu dem weiteren Widerstand (62) eine für den Fernspeisestrom ($I_F$) in Sperrrichtung gepolte Diode (61) angeordnet ist.

2. Schaltungsanordnung nach Anspruch 1, dadurch gekennzeichnet, daß die Induktivität der Drossel (4) derart bemessen ist, daß für den mit der RC-Serienschaltung beschalteten Thyristor (3) die Anstiegsgeschwindigkeit des Anodenstromes und die Anstiegsgeschwindigkeit der Anoden-Kathoden-Spannung jeweils kleiner als der für den Thyristor (3) vorgegebene Grenzwert sind.

3. Schaltungsanordnung nach Anspruch 1 oder 2, dadurch gekennzeichnet, daß die Anoden-Kathoden-Strecke des Thyristors (3) und die Drossel (4) unmittelbar in Serie geschaltet sind und daß parallel zu der Serienschaltung aus der Anoden-Kathoden-Strecke des Thyristors (3) und der Drossel (4) ein Varistor (5) angeordnet ist.

4. Schaltungsanordnung nach einem der Ansprüche 1 bis 3, dadurch gekennzeichnet, daß zwischen der Anode und der Steuerelektrode des Thyristors (3) ein Zweipol (7) mit einer Z-Diodenanordnung (71, 72) liegt, deren Zenerspannung derart bemessen ist, daß der Thyristor (3) etwa beim 1,2-fachen des Maximalwertes der am Ausgang der Speiseeinrichtung auftretenden Fernspeisespannung über den Zweipol (7) gezündet wird.

5. Schaltungsanordnung nach Anspruch 4, dadurch gekennzeichnet, daß die Induktivität der Drossel (4) derart bemessen ist, daß die Anstiegsgeschwindigkeit des Anodenstromes nach einem Zünden des Thyristors (3) über die Z-Diodenanordnung (71, 72) unterhalb des für den Thyristor (3) vorgegebenen Grenzwertes liegt.

6. Schaltungsanordnung nach einem der Ansprüche 1 bis 5, dadurch gekennzeichnet, daß die Nennspannung des Varistors (5) größer bemessen ist als die Spannung, die bei Unterbrechung der sich in Betrieb befindlichen Fernspeiseschleife und dem dadurch hervorgerufenen Schließen des Ruhekontaktes am Varistor (5) maximal auftritt.

7. Schaltungsanordnung nach einem der Ansprüche 4 bis 6, dadurch gekennzeichnet, daß in Serie zu der Z-Diodenanordnung (71, 72) eine Diode (73) liegt, deren Polung zu der der Z-Diodenanordnung (71, 72) entgegengesetzt ist.

## Claims

1. A circuit arrangement for the automatic closure of an interrupted remote-supply loop prior to an interruption point for remote-supply devices which supply electrical loads by series d. c. feed, where the ongoing part of one of the remote-supply paths contains an energising winding of a relay (1), and a shunt arm contains a series arrangement comprising a rest contact (10) of the relay, a resistor (2), and the conductively-poled anode-cathode path, relative to the remote-supply current ($I_F$), of a thyristor (3) whose control terminal is preceded by a delay circuit (9) which leads to the remote-supply loop via the rest contact, characterised in that a choke (4) is arranged in series with the anode-cathode path of the thyristor, that a series RC-circuit (63, 64) is arranged in parallel with the anode-cathode path of the thyristor (3), and that a diode (40), poled in the non-conducting direction with respect to the remote-supply current ($I_F$) is arranged parallel to the choke (4), and that the anode-cathode path of the thyristor (3) is arranged in parallel with a further resistor (62) which is contrived to be such that in the case of interference currents whose polarity is opposed to the direction of the remote-supply current ($I_F$), both the magnitude and the rate of build-up of the voltage occurring between the anode and cathode of the thyristor (3) remain below the limit values which govern the thyristor, and that a diode (61) that is poled in the non-conducting direction with respect to the remote-supply current ($I_F$) is arranged in series with the further resistor (62).

2. A circuit arrangement as claimed in Claim 1, characterised in that the inductance of the choke (4) is such that, for the thyristor (3) connected to the series RC-circuit, the rate of build-up of the anode current and of the anode-cathode voltage are in each case lower than the limit value which governs the thyristor (3).

3. A circuit arrangement as claimed in Claim 1 or 2, characterised in that the anode-cathode path of the thyristor (3) and the choke (4) are connected directly in series, and that a varistor (5) is arranged in parallel to the series arrangement of the anode-cathode path of the thyristor (3) and the choke (4).

4. A circuit arrangement as claimed in one of Claims 1 to 3, characterised in that between the anode and the control electrode of the thyristor (3) a two-terminal network (7) containing a Zener diode arrangement (71, 72) is arranged, the Zener voltage of which is such that the thyristor (3) is ignited via the two-terminal network (7) at approximately 1.2 times the maximum value of the remote-supply voltage which occurs at the output of the supply device.

5. A circuit arrangement as claimed in Claim 4, characterised in that the inductance of the choke (4) is such that the rate of build-up of the anode current following ignition of the thyristor (3) via the Zener diode arrangement (71, 72) is below the limit value which governs the thyristor (3).

6. A circuit arrangement as claimed in one of Claims 1 to 5 characterised in that the nominal voltage of the varistor (5) is greater than the maximum voltage occurring across the varistor (5) in the event of an interruption in the remote-supply loop during operation leading to closure of the rest contact.

7. A circuit arrangement as claimed in one of Claims 4 to 6, characterised in that the Zener diode arrangement (71, 72) is arranged in series with a diode (73) whose polarity is opposed to that of the Zener diode arrangement (71, 72).

**Revendications**

1. Montage pour la fermeture automatique d'une boucle de téléalimentation interrompue en amont d'un emplacement de coupure, pour des installations de téléalimentation qui alimentent des consommateurs d'électricité à l'aide d'un courant continu en série, du type dans lequel la partie aval de l'une des voies de téléalimentation comporte une bobine d'excitation d'un relais (1), alors que dans la branche transversale est monté un circuit série comportant un contact de repos (10) du relais, une résistance (2), et la piste anode-cathode d'un transistor (3) monté dans le sens passant par rapport au courant de téléalimentation ($I_F$), un circuit à retard (9) relié par l'intermédiaire d'un contact de repos à la bobine de téléalimentation, étant monté en amont de la borne de commande du thyristor, caractérisé par le fait qu'en série avec la piste anode-cathode du thyristor (3) est montée une self (4), et qu'en parallèle sur la piste anode-cathode du thyristor (3) est monté un circuit RC série (63, 64), et qu'en parallèle sur la self (4) est disposée une diode (40) montée dans le sens inverse du courant de téléalimentation ($I_F$), et qu'en parallèle sur la piste anode-cathode du thyristor (3) est montée une seconde résistance (62) dimensionnée de telle façon que dans le cas d'interventions de courants perturbateurs dont les polarités sont opposées au sens du courant de téléalimentation ($I_F$), aussi bien la valeur que la vitesse d'accroissement de la tension qui apparaît entre l'anode et la cathode du thyristor (3) reste en dessous des valeurs prédéterminées pour le thyristor, et qu'en série avec la seconde résistance (62) est prévue une diode en montage inverse.

2. Montage selon la revendication 1, caractérisé par le fait que l'inductance de la self (4) est dimensionnée de telle façon que pour le thyristor (3), monté avec le circuit série RC, la vitesse d'accroissement du courant anodique et la vitesse d'accroissement de la tension anode-cathode est inférieure à la valeur-limite prédéterminée pour le transistor (3).

3. Montage selon la revendication 1 ou 2, caractérisé par le fait que la piste anode-cathode du thyristor (3) et la self (4) sont montées directement en série, et qu'en parallèle au circuit série constitué par la piste anode-cathode du thyristor (3) et la self (4), est monté un varistor (5).

4. Montage selon l'une des revendications 1 à 3, caractérisé par le fait qu'entre l'électrode d'anode et l'électrode de grille du thyristor (3), est prévu un dipôle (7) avec un agencement à diodes Zener .(71, 72), dont la tension de Zener est dimensionnée de telle façon que le thyristor (3) est amorcé par le dipôle (7) à peu près pour une valeur égale à 1,2 la valeur maximale de la tension de téléalimentation qui apparaît à l'entrée du dispositif d'alimentation.

5. Montage selon la revendication 4, caractérisé par le fait que l'inductance de la self (4) est dimensionnée de telle façon que la vitesse d'accroissement du courant anodique, après l'amorçage du thyristor (3) par l'intermédiaire de l'agencement à diodes Zener (71, 72), se situe en dessous de la valeur-limite prédéterminée pour le thyristor (3).

6. Montage selon l'une des revendications 1 à 5, caractérisé par le fait que la tension nominale du varistor (5) est dimensionnée de façon plus forte que la tension qui, lors de l'interruption de la boucle de téléalimentation qui est en fonctionnement et de la fermeture qui en résulte pour le contact de repos, apparaît avec sa valeur maximale au varistor (5).

7. Montage selon l'une des revendications 4 à 6, caractérisé par le fait qu'en série avec l'agencement à diodes Zener (71, 72) est montée une diode (73) avec une polarité qui est opposée à celle de l'agencement à diodes Zener (71, 72).

0 119 552

# FIG 1

# FIG 2

1